# EUROPEAN PATENT SPECIFICATION

(11) **EP 1 942 709 B1**
(45) Date of publication and mention of the grant of the patent: **17.11.2010**
(21) Application number: 08100004.4
(22) Date of filing: 02.01.2008
(51) Int. Cl.: H05K 1/18, H05K 1/02, G02B 6/00, G02F 1/13

(54) **Flexible circuit board and liquid crystal display having the same**
Flexible Leiterplatte und Flüssigkristallanzeige damit
Carte de circuit flexible et affichage à cristaux liquides l'utilisant

(30) Priority: 03.01.2007 KR 20070000785; 03.01.2007 KR 20070000786; 03.01.2007 KR 20070000788; 03.01.2007 KR 20070000789
(43) Date of publication of application: 09.07.2008
(73) Proprietor: Samsung Mobile Display Co., Ltd., Suwon-si Gyeonggi-do (KR)
(72) Inventor: Chung, Jaemo, Gyeonggi-do (KR); Kim, Sunghwan, Gyeonggi-do (KR); Sung, Jinhee, Gyeonggi-do (KR)
(74) Representative: Hengelhaupt, Jürgen

(56) References cited:
- DE-A1- 10 350 099
- JP-A- 2003 242 817
- US-A- 4 439 818
- US-A1- 2006 006 777
- US-A1- 2006 082 297
- US-A1- 2006 268 551

## Description

### BACKGROUND OF THE INVENTION

### 1. Field of the Invention

Aspects of the present invention, relate to a flexible circuit board and, more particularly, to a liquid crystal display having the flexible circuit board.

### 2. Description of the Related Art

In general, a liquid crystal display is one of the flat panel displays that display images using a liquid crystal. Liquid crystal display is advantageous in that it is thinner and lighter than other displays, has a low driving voltage, and consumes little power. Accordingly, liquid crystal display is widely used throughout industry.

Such a liquid crystal display includes a thin film transistor (TFT) substrate, a color filter substrate opposite to the TFT substrate, and a liquid crystal display panel disposed between the two substrates and composed of the liquid crystal that changes the amount of light transmittance based on electrical signals applied thereto.

Moreover, a driving module to apply electrical signals to drive the liquid crystal display panel is coupled to the liquid crystal display. For this purpose, a flexible circuit board is generally disposed between the liquid crystal display panel and the driving module.

Since the liquid crystal included in the liquid crystal display panel does not emit light by itself, the liquid crystal display requires a light source that provides light having at least a predetermined brightness to the liquid crystal display panel so as to display an image.

A high-brightness light emitting diode is used as the light source to reduce the thickness and weight of small and mid-sized displays, such as cellular phones, portable multimedia players, and digital cameras. For example, the light source is coupled to the flexible circuit board and the light from the light source is provided to a light guide plate positioned on the rear of the liquid crystal display panel.

However, a portion of the light from the light source mounted on the flexible circuit board is not provided to the light guide plate but to the flexible circuit board or the driving module to drive the liquid crystal display panel. That is, light from the light source may be provided to conductive patterns that are formed on the flexible circuit board and to passive elements, such as resistors and capacitors, which are mounted thereon. Moreover, light from the light source may be applied to the driving module to drive the liquid crystal display panel. Since light from the light source has energy of a predetermined intensity, the energy may affect the conductive patterns, the passive elements, and the driving module. Thus, the passive elements and the driving module may malfunction. Accordingly, although the light source being mounted on the flexible circuit board is a technique that is necessary to meet the recent trend towards slim and lightweight devices, the reliability of the technique may be reduced by malfunctions of the various passive elements and the driving module caused by effects from the light.

Meanwhile, the flexible circuit board is connected to a mold frame at a predetermined position thereof during the manufacturing process of the liquid crystal display. Subsequently, the light guide plate is optically coupled to the flexible circuit board and arranged on the mold frame. Then, the liquid crystal display panel coupled to the flexible circuit board is positioned on the mold frame. US 2006/0268551 A1 discloses such a flexible circuit carrier for a liquid display. A light source having LEDs is coupled to a flexible circuit carrier including a sheet of flexible material having electrically conducting traces connecting a circuit mounting area an a connector region.

However, the mold frame does not include a reference position setting member to connect the flexible circuit board to the mold frame accurately. Accordingly, a deviation in a position may occur when the flexible circuit board is connected to the mold frame. Such a deviation does not allow the light guide plate to be optically coupled to the flexible circuit board accurately. Moreover, such a deviation does not allow the liquid crystal display panel to be coupled to the flexible circuit board accurately. As a result, the deviation between the mold frame and the flexible circuit board causes a deviation between the flexible circuit board and the light guide plate, and between the flexible circuit board and the liquid crystal display panel. Accordingly, image quality of the liquid crystal display deteriorates. US 2006/006777 A1 discloses a backlight assembly for a hand-held crystal display, which has an improved structure for eliminating the gap between the light guide plate and a light source. A display mold frame is provided that has two couplers at its front surface and close to coupling holes of a flexible printed circuit. The distance between the two coupler holes is substantially smaller than the distance between the couplers to generate a deformation force for fixing the mold frame and the flexible circuit board.

US 4, 439, 818 discloses a flexible electric lighting strip having a plurality of light emitting diodes. US 2006/0082297 discloses a circuit board wherein a black polymer is added to fill the space between light emitting diodes.

### SUMMARY OF THE INVENTION

Accordingly, an aspect of the present invention provides a flexible circuit board that is configured to prevent or reduce light from a light source from being introduced into undesired areas, such as conductive patterns, passive elements, and the like.

Another aspect of the present invention provides a liquid crystal display that is configured to connect the flexible circuit board and a light guide plate and the flexible circuit board and a liquid crystal display panel, accurately with one another by mounting the flexible circuit board on a predetermined position of a mold frame accurately.

To accomplish the above and/or other aspects, a flexible circuit board (for a liquid crystal display) in accordance with an aspect of the present invention may include: a first insulating film; a plurality of conductive patterns (preferably conductive pads) formed on the first insulating film; a second insulating film formed on the first insulating film to cover the plurality of conductive patterns; at least one light source coupled to the conductive patterns; a light absorbing layer formed on the outer circumference of the light source to prevent light from the at least one light source from being emitted to undesired areas, a first region, in which the light source and the light absorbing layer may be formed, a second region, established on one side of the first region, to which a liquid crystal display panel may be coupled, and a third region, arranged on one side of the second region, to which an external controller may be coupled.

Preferably, the light absorbing layer may include a first light absorbing layer formed on the first insulating film and a second light absorbing layer established on the second insulating film corresponding to the outer circumference of the light source.

Preferably, a window may be formed on the second light absorbing layer so that the plurality of conductive patterns to which the at least one light source is coupled may be exposed to the outside.

Preferably, the dimensions of the window may be greater than those of the plurality of the conductive patterns.

Preferably, the circumference of the window may be spaced apart from that of the conductive pattern by about 0.1 mm to about 0.4mm.

Preferably, the dimensions of the first light absorbing layer may be greater than those of the second light absorbing layer.

Preferably, at least one passive element coupled to the plurality of the conductive patterns may be further formed on the outer circumference of the second light absorbing layer.

Preferably, the first light absorbing layer may be further formed on the surface of the first insulating film corresponding to the at least one passive element.

Preferably, the second light absorbing layer may include a front second light absorbing layer formed toward the front of the light source and a rear second light absorbing layer formed toward the rear of the at least one light source.

Preferably, the dimensions of the front second light absorbing layer may be greater than those of the rear second light absorbing layer.

Preferably, the front second light absorbing layer and the rear second light absorbing layer may be formed in a shape of a triangle, a rectangle and/or a trapezoid; respectively.

Preferably, the front second light absorbing layer and the rear second light absorbing layer may be formed in a body on the outer circumference of the light source.

Preferably, the front second light absorbing layer and the rear second light absorbing layer may be formed spaced apart from each other centering on the light source.

Preferably, the light absorbing layer may be composed of DCAC (diethylene glycol monoethyl ether acetate), titanium dioxide, and/or epoxy resin.

Preferably, the at least one light source may be a light emitting diode.

Preferably, the first insulating film may include the first, second and third region.

Preferably, first cutout .portions spaced apart from each other may be formed bisymmetrically in the second region, a second cutout portion may be formed between the first cutout portions, and a panel connector coupled to a liquid crystal display may be further established in a cutout region formed by the first cutout portions and the second cutout portion.

Preferably, a conductive pattern of the panel connector may be formed exposed to the outside of the first insulating film.

Preferably, a controller connector coupled to an external controller may be formed in the third region.

Preferably, a conductive pattern of the controller connector may be formed exposed to the outside of the first insulating film.

Preferably, fixing holes may be further provided at opposite positions to each other in the first region and the third region.

In accordance with an aspect of the present invention a liquid crystal display is disclosed, the liquid crystal display comprising a liquid crystal display panel and a driving module to apply electrical signals to drive the liquid crystal display panel which is coupled to the liquid crystal display, wherein a flexible circuit board according to at least one of the above features (as disclosed in the summary of the invention) is disposed between the liquid crystal display panel and the driving module.

To accomplish the above and/or other aspects, a liquid crystal display in accordance with an aspect of the present invention may include: a mold frame, of which the middle may be opened; a flexible circuit board, connected to the mold frame and including a light source, a passive element to provide light to the middle of the mold frame and at least one light absorbing layer formed in a peripheral portion of the at least one light source adapted to prevent light from the at least one light source from being emitted to the at least one passive element, and fitted to the mold frame by a cutout portion formed thereon; a light guide plate mounted on the mold frame and optically coupled to the light source on the flexible circuit board to emit light; and a liquid crystal display panel mounted on the light guide plate corresponding to the inside of the mold frame and coupled to the flexible circuit board to display an image, wherein a guide boss, to which the cutout portion of the flexible circuit board may be connected and fixed, may be further established on the mold frame.

Preferably, the mold frame may include an outer frame and an inner frame formed inside the outer frame, and the guide boss may be established on the inner frame.

Preferably, the inner frame may include a first inner frame section formed in an area that does not meet the outer frame, a second inner frame section, a third inner frame section and a fourth inner frame section, those being established in areas that meet the out frame, and the first inner frame section, the second inner frame section, the third inner frame section and the fourth inner frame section may be connected to each other.

Preferably, the guide boss may be formed on the first inner frame section.

Preferably, a plurality of cutout portions may be formed on the first inner frame section and the light source of the flexible circuit board may be inserted to the cutout portion.

Preferably, a plurality of through-holes may be formed on the first inner frame section and the passive element of the flexible circuit board may be inserted to the through-hole.

Preferably, a plurality of fixing holes may be formed on the flexible circuit board.

Preferably, a plurality of protrusions may be formed on the first inner frame section and the fixing holes of the flexible circuit board may be inserted to the protrusions.

Preferably, the guide boss may be a cylindrical shape.

Preferably, the outer frame may be a ⊏ shape.

Preferably, the thickness of the outer frame, may be greater than that of the inner frame.

In an aspect of the present invention, as described above, the flexible circuit board minimizes the introduction of light from the light source to the passive elements, the conductive patterns, and the driving module by further establishing the light absorbing layer on the outer circumference of the light source. Accordingly, aspects of the present invention prevent or reduce the malfunctions of the passive elements and the driving module and further improve the image quality of the liquid crystal display panel.

In an aspect of the present invention, a flexible circuit board includes a base layer having conductive patterns; a light source connected to the conductive patterns formed on a first section of the base layer; a panel connector of the conductive patterns and an ink layer formed on a second section of the base layer; a controller connector of the conductive patterns formed on a third section of the base layer; and a light absorbing layer formed in the first section, wherein the light absorbing layer is formed over portions of the light source and the first section, and the second section is folded over one side of the first section and the third section is folded over another side of the first section.

In an aspect of the present invention, the flexible circuit board forms the light sources and the passive elements in the first region thereof, establishes the panel connector, to which the liquid crystal display panel is coupled, in the second region thereof, and arranges the controller connector, coupled to the external controller, in the third region thereof. Accordingly, it is possible to electrically connect a large number of parts to each other in a minimum of an area efficiently to thereby easily apply the flexible circuit board of the aspects of the present invention to slim and lightweight portable displays.

In an aspect of the present invention, the first region, the second region and the third region of the flexible circuit board in accordance with aspects of the present invention are composed of the flexible first and second insulating films. Accordingly, desired areas can be readily bent to thereby easily apply the flexible circuit board of the aspects of the present invention to various kinds of portable displays having a lot of bending portions.

In an aspect of the present invention, the liquid crystal display includes the flexible circuit board which can be connected to an accurate position of the mold frame by the guide bosses formed on the mold frame. Accordingly, the flexible circuit board and the light guide plate are also optically coupled to each other in an accurate position, and the flexible circuit board and the liquid crystal display panel are also coupled to each other in an accurate position. As a result, the image quality of the liquid crystal display is remarkably improved.

Additional aspects and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the aspects, taken in conjunction with the accompanying drawings of which:
FIGS. 1A, 1B, and 1C are a top plan view, a side elevational view, and a bottom plan view depicting a flexible circuit board in accordance with an aspect of the present invention;
FIG. 2A is a top plan view depicting a flexible circuit board without a mounted light source and FIG. 2B is an enlarged view depicting an area 2b of FIG. 2A;
FIG. 3 is a cross-sectional view of line 3-3 of FIG. 1;
FIG. 4 is a cross-sectional view of line 4-4 of FIG. 1;
FIG. 5 is a cross-sectional view of line 5-5 of FIG. 1;
FIG. 6 is a cross-sectional view of line 6-6 of FIG. 1;
FIG. 7 is a cross-sectional view of line 7-7 of FIG. 1;
FIGS. 8A, 8B, and 8C are top plan views depicting flexible circuit boards in accordance with aspects of the present invention;
FIG. 9 is an exploded perspective view depicting a liquid crystal display in accordance with an aspect of the present invention;
FIG. 10 is a partial cross-sectional view of the liquid crystal display in accordance with an aspect of the present invention;
FIG. 11 is a perspective view depicting a mold frame of the liquid crystal display in accordance with an aspect the present invention; and
FIG. 12 is a perspective view depicting a flexible circuit board that is connected to the mold frame of the liquid crystal display in accordance with an aspect of the present invention.

### DETAILED DESCRIPTION OF THE EMBODIMENTS

Reference will now be made in detail to the aspect of the present invention, examples of which are illustrated in the accompanying drawings, wherein like reference numerals refer to the like elements throughout. The aspects are described below in order to explain the present invention by referring to the figures.

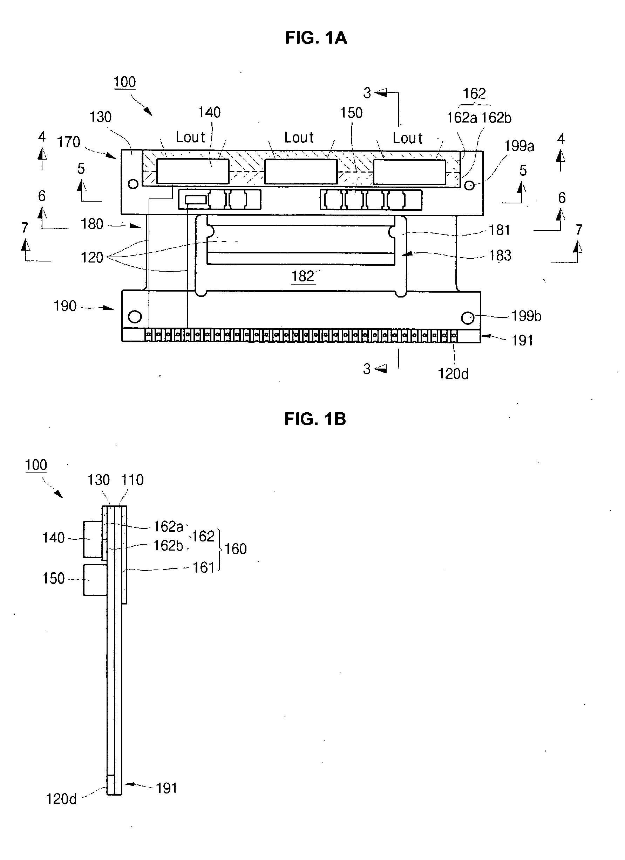

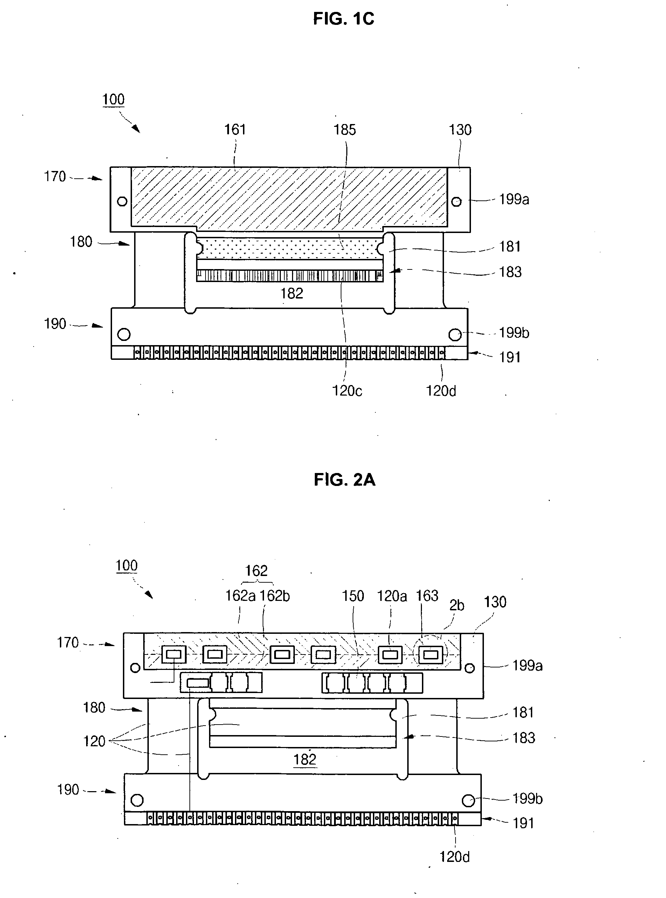

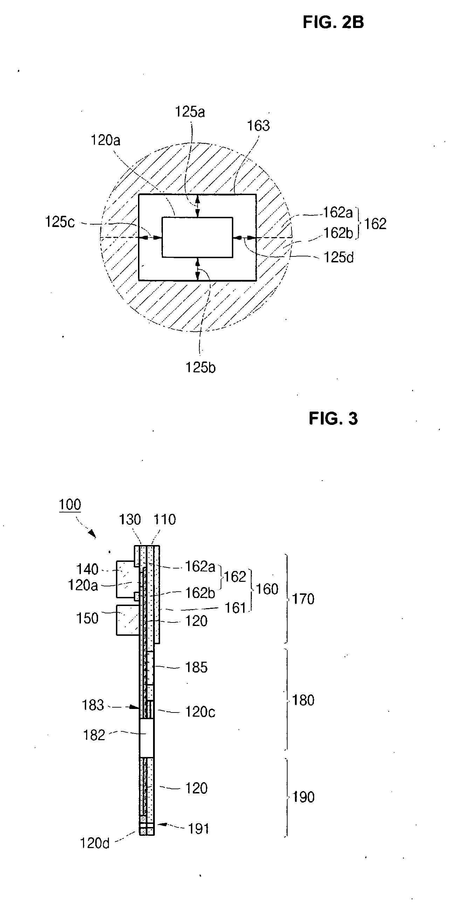

Referring to FIGS. 1A, 1B, 1C, a top plan view, a side elevational view, and a bottom plan view of a flexible circuit board in accordance with an aspect of the present invention are depicted. In various aspects, in FIG. 2A, a top plan view of a flexible circuit board without a mounted light source is depicted, and an enlarged view of an area 2b of FIG. 2A is depicted in FIG. 2B.

As depicted in FIGS. 1A, 1B, and 1C and FIGS. 2A and 2B, the flexible circuit board 100 of liquid crystal display includes a first insulating film 110, a conductive pattern or patterns 120, a second insulating film 130, a light source or sources 140, a passive element or elements 150, and a light absorbing layer or layers 160.

In a non-limiting aspect shown, the first insulating film 110 is a base layer of the flexible circuit board 100 and is formed with a flexible polyimide and/or equivalents thereof. However, the material is not limited thereto.

In a non-limiting aspect shown, the conductive pattern 120 is formed on the first insulating film 110. Such a conductive pattern 120 may be formed with a copper thin film having high conductivity, and/or equivalents thereof. However, the material is not limited thereto. The conductive pattern 120 may supply power or electrical signals to various electronic parts, such as the light source 140 or the passive element 150, which are coupled to the flexible circuit board 110. Although only a portion of conductive patterns 120 is depicted in FIG. 1A and FIG. 2A, the number of conductive patterns 120 may be any number from several tens to several thousands. In various aspects, the conductive patterns 120 are not readily visible to the outside as the second insulating film 130 is nearly opaque.

In a non-limiting aspect shown, the second insulating film 130 is formed on the first insulating film 110 to cover the conductive patterns 120. Accordingly, the second insulating film 130 prevents the conductive patterns 120 from being exposed to the outside and damaged. Of course, the second conductive film 130 is not formed on the conductive patterns 120 to which the light source 140 or the passive element 150, for example, are coupled. The second insulating film 130 may be a flexible cover film and/or equivalents thereof. However, the material is not limited thereto.

In a non-limiting aspect shown, the light source 140 is coupled to the conductive pattern 120. Substantially, a conductive pad 120a is established (or formed) on the conductive pattern 120, and the conductive pad 120a is exposed to the outside of the second insulating film 130. Accordingly, the light source 140 may be coupled to the conductive pad 120a by soldering/or other attaching, joining, and/or adhering techniques. In various aspects, the light source 140 may be a high-brightness light emitting diode and/or equivalents thereof. However, the material is not limited thereto. Furthermore, although three light sources 140 arranged in a row are depicted in FIG. 1A, the number of the light sources 140 is not limited thereto. In various aspects, "Lout" in FIG. 1A depicts the direction and the angle of the light emitted from the light source 140.

In a non-limiting aspect shown, the passive element 150 is coupled to the conductive pattern 120. In a non-limiting aspect shown,, the conductive pad 120a established (or formed) on the conductive pattern 120 is exposed to the outside of the second insulating film 130. Accordingly, the passive element 150 may be coupled to the conductive pad 120a by soldering and/or other attaching, joining, and/or adhering techniques. In a non-limiting aspect shown, the passive element 150 may be a resistor, a capacitor and/or an inductor. However, the kind of the passive element 150 is not limited thereto. In various aspects, although seven passive elements 150 arranged in a row are depicted in the figures, the number of the passive elements 150 is not limited thereto.

In a non-limiting aspect shown, the light absorbing layer or layers 160 may be composed (or formed) of a first light absorbing layer or layers 161 formed on the first insulating film 110 and a second light absorbing layer or layers 162 established (or formed) on the second insulating film 130. The first light absorbing layer 161 may be formed on the first insulating film 110 corresponding to a side opposite to a side to which the light sources 140 and the passive elements 150 are coupled. In various aspects, the second light absorbing layer or layers 162 may be established (or formed) on the second insulating film 130 corresponding to the outer circumference of the light source 140. Furthermore, the second light absorbing layer or layers 162 may be composed of a front (or a first) second light absorbing layer 162a formed in an area (front) where the light from the light source 140 is emitted and a rear (or second) second light absorbing layer 162b established (or formed) on the opposite area (rear) to the area where the light from the light source 140 is emitted. Of course, the front second light absorbing layer 162a and the rear second light absorbing layer 162b may be connected directly with each other or spaced apart from each other at regular intervals. In various aspects, since the front second light absorbing layer 162a is formed in the area where the light from the light source 140 are emitted in large quantities, it is desirable that the dimensions of the front second light absorbing layer 162a is set to be greater than the dimensions of the rear second light absorbing layer 162b.

In non-limiting aspects,, the second light absorbing layer 162 is arranged spaced apart from the conductive pad 120a at regular intervals so that the light source 140 may be readily coupled to the conductive pad 120a that is exposed through the second insulating film 130. In more detail, the front second light absorbing layer 162a and the rear second light absorbing layer 162b may be arranged spaced apart from the conductive pad 120a so that the light source 140 is readily coupled to the conductive pad 120a exposed through the second insulating film 130. The area where the second light absorbing layer 162 is arranged spaced apart from the conductive pad 120a at regular intervals as described above is defined as a window 163. That is, the window 163 is formed on the second light absorbing layer 162 so that the conductive pad 120a may be exposed to the outside through the window 163. In other words, the dimensions of the window 163 may be set to be greater than the dimensions of the conductive pad 162a.

In a non-limiting aspect shown in FIG. 2B, an enlarged view of area 2b of FIG. 2A is depicted. A top distance 125a, a bottom distance 125b, a left distance 125c, and/or a right distance 125d that are spaced between the conductive pad 162a and the second light absorbing layer 162 may be about 0.1 mm to about 0.4 mm. As shown, if the spaced distance or distances are less than about 0.1 mm, a portion of the conductive pads 120a may be covered by the second light absorbing layer 162 due to errors caused during the formation of the second light absorbing layer 162. On the other hand, if the spaced distance or distances are more than about 0.4 mm, light from the light source 140 may be provided to the conductive pattern 120 through the space between the conductive pad 120a and the second light absorbing layer 162.

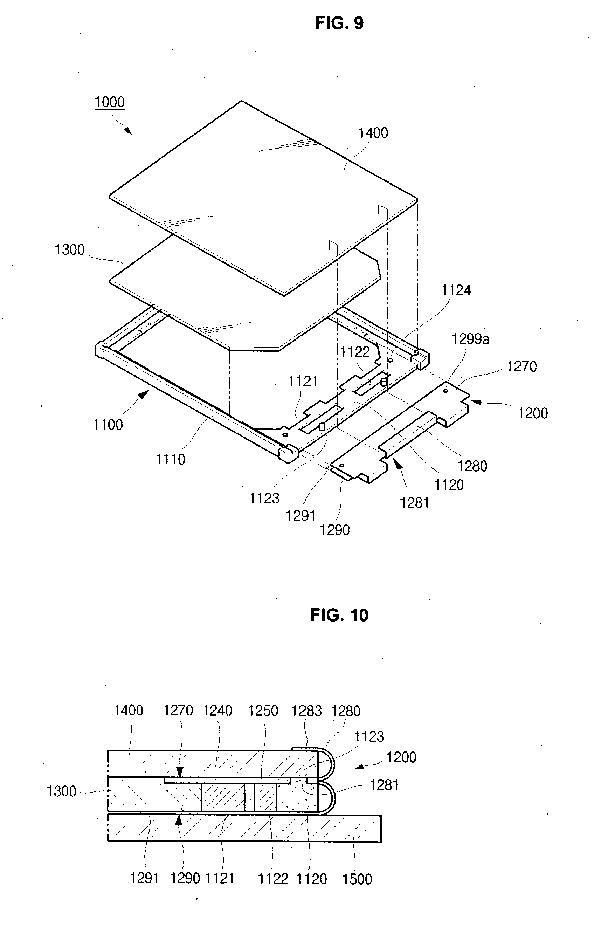

In the first light absorbing layer 161 and the second light absorbing layer 162 as described above, the light from the light source 140 is not or hardly leaked to the conductive patterns 120 and the passive elements 150. That is, the light from the light source 140 is provided only to the light guide plate (shown in FIG. 9), not to the conductive patterns 120 and/or the passive elements 150. In various aspects, the light absorbing layer 160 may include DCAC (diethylene glycol monoethyl ether acetate) (C₈H₁₆O₄), titanium dioxide (TiO₂), epoxy resin, and/or equivalents thereof. However, the material of the light absorbing layer 160 is not limited thereto. The light absorbing layer 160 is generally called black silk as it is blackish (or black in color). In various aspects, the light absorbing layer 160 absorbs the light from the light source more efficiently because it is blackish. Furthermore, the light absorbing layer 160 may be formed by a screen printing, a photo-lithography, and/or an equivalent method. However, the formation method is not limited thereto. In addition, the light absorbing layer 160 may be formed by electroless plating and/or by electroplating, and/or further formed by coating a black polymer resin.

In a non-limiting aspect shown,, the flexible circuit board 100 of liquid crystal display may be divided into a first region (or section) 170, a second region (or section) 180, and a third region (or section) 190. In a non-limiting aspect shown, the first region 170 is an area on which the light sources 140, the passive elements 150, and the light absorbing layer 160, as described above, are arranged. As shown, the first light absorbing layer 161 of the light absorbing layer 160 may be formed all or partially over the first insulating film 110 corresponding to the first region 170. In various aspects, the second light absorbing layer 162 of the light absorbing layer 160 may be formed on a portion of the second insulating film 130. That is, the second light absorbing layer 162 is formed only on (or over) the light source 140, but not on (or over) the passive element 150. Accordingly, the dimensions of the first light absorbing layer 161 are set to be greater than those of the second light absorbing layer 162.

In a non-limiting aspect shown, the second region 180 is formed on one side of the first region 170, and a panel connector 183 to which a liquid crystal display panel is coupled may be arranged therein. As shown, first cutout portions 181 spaced apart from each other at regular intervals are formed in the second region 180, and a second cutout portion 182 may be established (or formed) between the first cutout portions 181. Accordingly, the first cutout portions 181 and the second cutout portion 182 may be arranged in an approximately H shape (or a block U shape). In various aspects, the panel connector 183 to which a liquid crystal display panel is coupled may be established (or formed) in a cutout region formed by the first cutout portions 181 and the second cutout portion 182. Of course, a plurality of conductive patterns 120c (See FIG. 1C) in the panel connector 183 may be exposed to the outside through the first insulating film 110. Reference numeral 185 in FIG. 1C denotes an ink layer having a higher flexibility than that the first insulating film 110 so that the bending (or folding) thereof is more readily made (or performed).

In a non-limiting aspect shown, the third region 190 is established (or formed) on (or to) one side of the second region 180, and a controller connector 191 coupled to an external controller (not shown) may be arranged therein. Of course, a plurality of conductive patterns 120d in the controller connector 191 may be exposed to the outside through the first insulating film 110 and/or the second insulating film 130. In various non-limiting aspects, a light absorbing layer like the second light absorbing layer 162 may be formed on the third region 190.

In various aspects, fixing holes 199a and 199b may be established (or formed) at positions opposite to each other in the first region 170 and the third region 190. The fixing holes 199a and 199b function to firmly fix the flexible circuit board 100 to a mold frame (shown in FIG. 9) when the flexible circuit board 100 is connected with protrusions (shown in FIG. 9) of the mold frame.

Referring to FIG. 3, a cross-sectional view of line 3-3 of FIG. 1 is depicted. As depicted in FIG. 3, the flexible circuit board 100 is divided into the first region 170, the second region 180 and the third region 190. In the first region 170, the light sources 140 may be coupled to the conductive pads 120a formed on the conductive patterns 120. In various aspects, the passive elements 150 may be coupled to the conductive pads 120a formed on the conductive patterns 120. The first light absorbing layer 161 may be formed on the surface of the first insulating film 110 in the first region 170. In various aspects, the second light absorbing layer 162 may be formed on the surface of the second insulating film 130 in the first region 170. As shown, the second light absorbing layer 162 includes the window on the outer circumference of the conductive pad 120a so as to readily electrically connect the light source 140 to the conductive pad 120a. Accordingly, the light from the light source 140 is not provided to the passive elements 150 through the conductive patterns 120 by such a structure. In various aspects, the second light absorbing layer 162 is not formed in the areas corresponding to the passive elements 150.

In a non-limiting aspect shown, the panel connector 183 may be formed in the second region 180, and the conductive pads 120c established (or formed) on the conductive patterns 120 in the panel connector 183 may be exposed to the outside. In various aspects, the ink layer 185 having higher flexibility than that of the first insulating film 110 may be formed in the second region 180 so that the bending (or folding) thereof may be readily performed (made). Such an ink layer 185 may be a UV curing ink, an IR ink, and/or equivalents thereof. However, the material is not limited thereto.

In various aspects, the controller connector 191 may be formed in the third region 190 and the conductive pads 120d that are established (or formed) on the conductive patterns 120 in the controller connector 191 may be exposed to the outside.

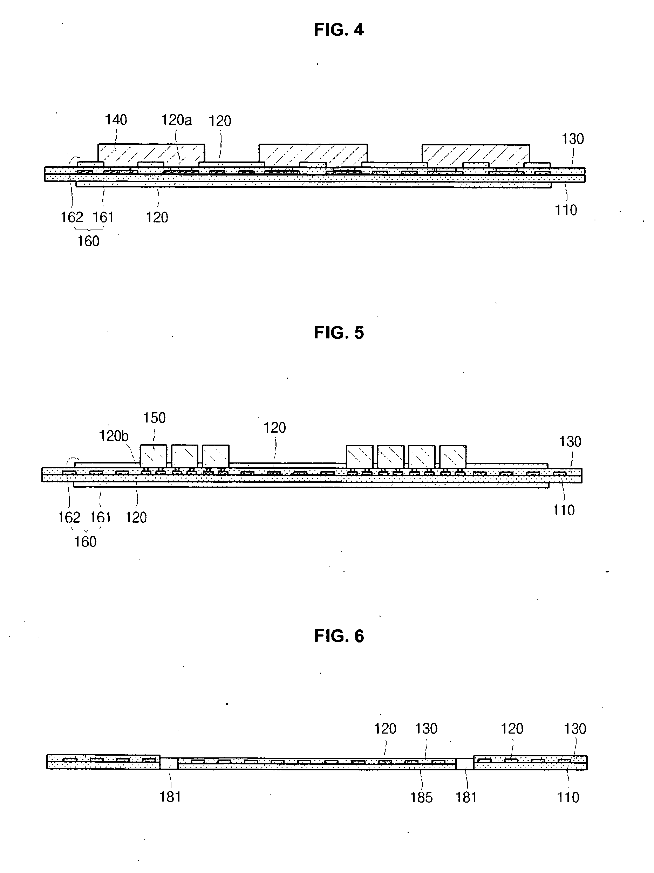

Referring to FIG. 4, a cross-sectional view of line 4-4 of FIG. 1 is depicted. As depicted in the figure, the light sources 140 (such as the high-brightness light emitting diodes) may be mounted spaced apart from each other at regular intervals on the flexible circuit board 100. Each of the light sources 140 may be coupled to the conductive pad 120a formed on the conductive patterns 120 by soldering and/or other attaching, joining, and/or adhering techniques. Accordingly, the respective light sources 140 may receive power through the conductive pads 120a and the conductive patterns 120. In various aspects, the first light absorbing layer 161 may be formed on the surface of the first insulating film 110 and the second light absorbing layer 162 may be arranged (or formed) on the surface of the second insulating film 130. Accordingly, light from the light source 140 is not provided to the conductive patterns 120.

Referring to FIG. 5, a cross-sectional view of line 5-5 of FIG. 1 is depicted. As depicted in the figure, the passive elements 150, such as resistors, capacitors and/or inductors, may be mounted at regular intervals on the flexible circuit board 100. In various aspects, each of the passive elements 150 may be coupled to the conductive pad 120a formed on the conductive pattern 120 by soldering and/or other attaching, joining, and/or adhering techniques to thereby enable the respective passive elements 150 to receive power through the conductive pads 120b and the conductive patterns 120.

Referring to FIG. 6, a cross-sectional view of line 6-6 of FIG. 1 is depicted. As depicted in the figure, instead of the first insulating film 110, the ink layer 185 that is more readily (or easily) bent (or folded) may be formed on the flexible circuit board 100 in the second region 180. That is, the second insulating film 130 may be adhered to the ink layer 185 rather than to the first insulating film 110. According to non-limiting aspects of the present invention, the second region 180 may be readily bent (or folded). That is, while the panel connector 183 in the second region 180 is bent (or folded) at a predetermined angle so as to be coupled to the liquid crystal display panel, the bending area (or the folded area) may be damaged by the concentrated stress thereon. Accordingly, instead of the first insulating film 110, the ink layer 185 is formed on the second region 180 so that the second region 180 may not be damaged by stress during the bending process.

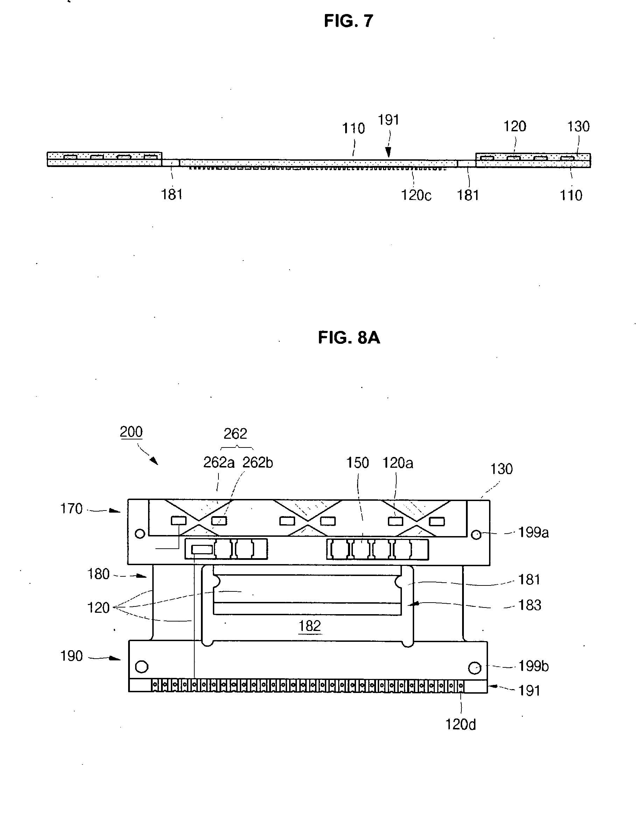

Referring to FIG. 7, a cross-sectional view of line 7-7 of FIG. 1 is depicted. As depicted in the figure, the panel connector 183 to which the liquid crystal display panel is coupled may be further formed in the second region 180 of the flexible circuit board 100. The panel connector 183 may be a plurality of conductive patterns 120c exposed to the outside of the first insulating film 110. That is, the plurality of the conductive patterns 120c are coupled to the liquid crystal display panel to thereby enable various electrical signals to be supplied to the liquid crystal display panel through the external controller connector 191.

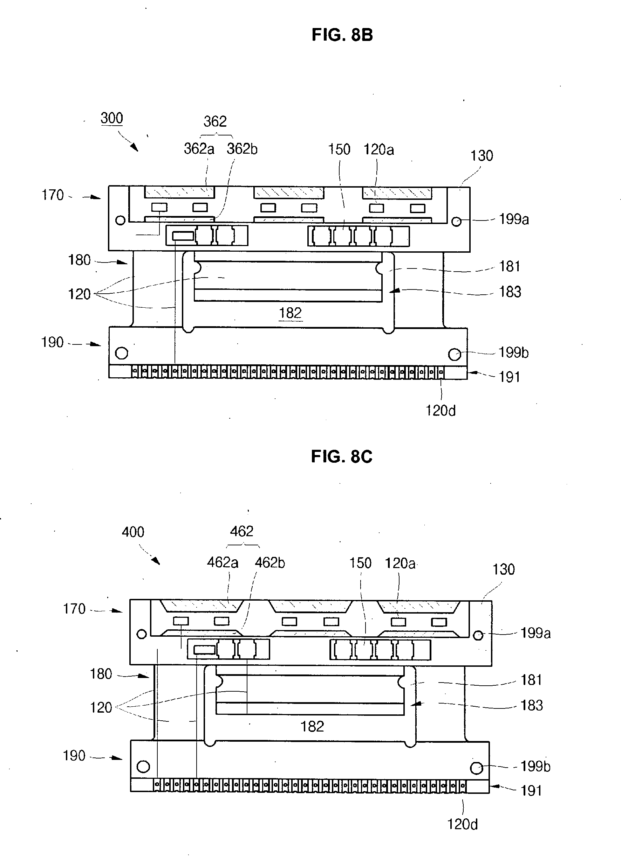

Referring to FIGS. 8A, 8B, and 8C, top plan views of flexible circuit boards in accordance with aspects of the present invention are depicted. As shown, since the flexible circuit boards 200, 300 and 400 depicted in FIGS. 8A, 8B, and 8C have substantially the identical structure as the above-described flexible circuit board 100, the description will be based on the differences between them.

In the flexible circuit board 200 depicted in FIG. 8A, a front second light absorbing layer 262a and a rear second light absorbing layer 262b may be respectively formed on different sides of the conductive pads 120a. In a non-limiting aspect shown, the front second light absorbing layer 262a in an inverted triangular shape may be formed on (or to) one side of two conductive pads 120a, and the rear second light absorbing layer 262b in a triangular shape may be established (or formed) on (or to) the other side of the two conductive pads 120a. In the non-limiting aspect shown, the dimensions of the front second light absorbing layer 262a are set to be greater than those of the rear second light absorbing layer 262b to enable emission of a relatively greater amount of light toward the front second light absorbing layer 262a. In various aspects, although the front second light absorbing layer 262a and the rear second light absorbing layer 262b are depicted as being spaced apart from each other at regular intervals, in other aspects, they may be in contact with each other.

In a non-limiting aspect of the flexible circuit board 300 depicted in FIG. 8B, a front second light absorbing layer 362a and a rear second light absorbing layer 362b may be formed respectively on different sides of the conductive pads 120a. In the non-limiting aspect shown, the front second light absorbing layer 362a in a rectangular shape may be formed on (or to) one side of two conductive pads 120a, and the rear second light absorbing layer 362b in a rectangular shape may be established (or formed) on (or to) the other side of the two conductive pads 120a. In the non-limiting aspect shown, the dimensions of the front second light absorbing layer 362a are set to be greater than those of the rear second light absorbing layer 362b to enable emission of a relatively greater amount of light toward the front second light absorbing layer 362a. In various aspects, although the front second light absorbing layer 362a and the rear second light absorbing layer 362b are depicted as being spaced apart from each other at regular intervals in the figure, in other aspects, they may be in contact with each other.

In a non-limiting aspect of the flexible circuit board 400 depicted in FIG. 8C, a front second light absorbing layer 462a and a rear second light absorbing layer 462b may be formed respectively on different sides of the conductive pads 120a. In the non-limiting aspect shown, the front second light absorbing layer 462a in a trapezoid shape may be formed on (or to) one side of two conductive pads 120a, and a rear second light absorbing layer 462b in a trapezoid shape may be established (or formed) on (or to) the other side of the two conductive pads 120a. In the non-limiting aspect shown, the dimensions of the front second light absorbing layer 462a are set to be greater than those of the rear second light absorbing layer 462b to enable emission of a relatively greater amount of light toward the front second light absorbing layer 462a. In various aspects, although the front second light absorbing layer 462a and the rear second light absorbing layer 462b are depicted as being spaced apart from each other at regular intervals in the figure, in other aspects, they may be in contact with each other.

Referring to FIG. 9, an exploded perspective view of a liquid crystal display in accordance with an aspect of the present invention is depicted. As depicted in the figure, a liquid crystal display panel 1000 includes a mold frame 1100, a flexible circuit board 1200, a light guide plate 1300, and a liquid crystal display panel 1400. In the aspect shown, the flexible circuit board 1200 has the same structure as the above-described flexible circuit board 100. Accordingly, the descriptions of the flexible circuit board 1200 that overlap with those of the flexible circuit board 100 will be kept to a minimum.

In the non-limiting aspect shown, the mold frame 1100 includes an outer frame 1110 and an inner frame 1120. The outer frame 1110 may be established in an approximately ⊏ shape (e.g., a block C shape or a rotated block U shape), having an opened side, and the inner frame 1120 having a predetermined width arranged inside the outer frame 1110. Cutout portions 1121, through-holes 1122, guide bosses 1123, and protrusions 1124 may be formed in the inner frame 1120. In various aspects, the inner frame 1120 has a rectangular shape of which the center is opened.

In the non-limiting aspect shown, the flexible circuit board 1200 may be connected to the inner frame 1120 in the mold frame 1110. That is, a first region 1270 of the flexible circuit board 1200 may be placed on the inner frame 1120, a second region 1280 thereof may be bent upward (or in a first direction) and be coupled to the liquid crystal display panel 1400, and a third region 1290 thereof may be bent downward (or a second direction different from the first direction) and be positioned below the inner frame 1120.

In the non-limiting aspect shown, the light guide plate 1300 may be placed on the inner frame 1120 in the mold frame 1110 and be optically coupled to the flexible circuit board 1200. In the non-limiting aspect shown, the liquid crystal display panel 1400 may be placed on the light guide plate 1300 and be coupled to the flexible circuit board 1200. In this aspect, a cutout portion 1281 of the flexible circuit board 1200 is connected to the guide bosses 1123 formed on the inner frame 1120, and fixing holes 1299a of the flexible circuit board 1200 are joined to the protrusions 1124 established (or formed) on the inner frame 1120.

Referring to FIG. 10, a partial cross-sectional view of the liquid crystal display in accordance with an aspect of the present invention is depicted. As depicted in the figure, a light source 1240 formed on the flexible circuit board 1200 may be connected with the cutout portion 1121 of the inner frame 1120 and one side thereof may be optically coupled to the light guide plate 1300. In various aspects, a passive element 1250 formed on the flexible circuit board 1200 may be connected to the through-holes 1122 of the inner frame 1120. Furthermore, the cutout portion 1281 of the flexible circuit board 1200 is connected to the guide bosses 1123 of the inner frame 1120. Accordingly, the flexible circuit board 1200 is firmly fixed to the inner frame 1120.

In various aspects as depicted in the figure, the first region 1270 of the flexible circuit board 1200 may be disposed between the top of the inner frame 1120 and the bottom of the liquid crystal display panel 1400. The second region 1280 of the flexible circuit board 1200 may be bent (or folded) upward (or a first direction) to be coupled to the liquid crystal display panel 1400. Furthermore, the third region 1290 of the flexible circuit board 1200 may be bent (or folded) downward (or a second direction different from the first direction) to be positioned between the light guide plate 1300 and an external connector 1500, and be coupled to the external connector 1500.

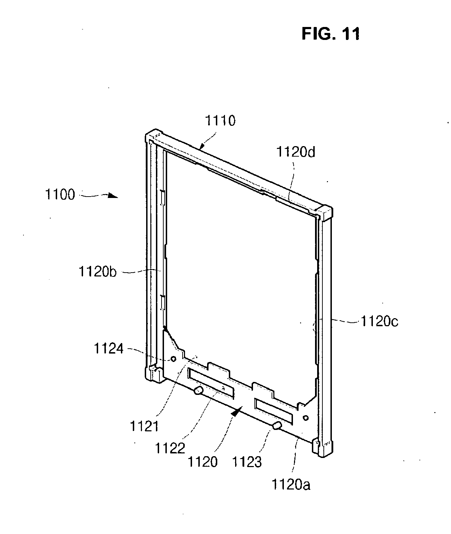

Referring to FIG. 11, a perspective view of the mold frame of the liquid crystal display in accordance with an aspect of the present invention is depicted. As depicted in the figure, the mold frame 1100 includes the outer frame 1110 and the inner frame 1120. The outer frame 1110 may be established (or formed) in an approximately ⊏ shape (e.g., a block C shape or a rotated block U shape) having one side that is opened, and the inner frame 1120 may be formed in an approximately rectangular ring shape inside the outer frame 1110. The light guide plate and the liquid crystal display panel may be placed on the inner frame as described above. The inner frame 1120 may be divided into four portions including a first inner frame section 1120a, a second inner frame section 1120b, a third inner frame section 1120c, and a fourth inner frame section 1120d. In various aspects, the first to fourth inner frame sections 1120a to 1120d may be connected to each other, and the second to fourth inner frame sections 1120b to 1120d may be directly connected to the outer frame 1110. In various aspects, the first inner frame section 1120a may connect the outer frame 1110, i.e., the second inner frame section 1120b and the third inner frame section 1120c to each other. In various aspects, the first to fourth inner frame sections 1120a to 1120d may have a smaller thickness than that of the outer frame 1110 and extend to the inside thereof by a predetermined length. In various aspects, the first inner frame section 1120a may have greater dimensions than those of the second to fourth inner frame sections 1120b to 1120d.

In the non-limiting aspect shown, a plurality of cutout portions 1121 may be formed on the first inner frame section 1120a. Three cutout portions 1121 are depicted in FIG. 11 for sake of convenience. However, the number of the cutout portions 1121 is not limited thereto. In various aspects, the cutout portion 1121 may be formed toward the fourth inner frame section 1120d. The cutout portion 1121 may be formed in a rectangular shape and the top thereof may be opened. As described above, the light source (such as 140) on the flexible circuit board 1200 is connected to the cutout portion 1121. That is, since the flexible circuit board 1200 may include three light sources, three cutout portions 1121 may be established on the first inner frame section 1120a, as in the figures. In various aspects, the numbers of the light sources and/or the cutout portions 1121 are not limited thereto.

In the non-limiting aspect shown, a plurality of through-holes 1122 may be formed on the first inner frame section 1120a. Such through-holes 1122 may number two as depicted in the figure. However, the number of the through-holes 1122 is not limited thereto. In various aspects, the through-hole 1122 may be formed in a rectangular shape and/or be opened. In various aspects, the through-hole 1122 may be established on one side of the cutout portion 1121 on the first inner frame section 1120a. As described above, the plural passive elements on the flexible circuit board are connected to the through-holes 1122. That is, since the flexible circuit board 1200 may include a two-passive element group, two through-holes 1122 may be established on the first inner frame section 1120a, as seen in the figures. In various aspects, the numbers of the passive elements and the through-holes 1122 are not limited thereto.

In the non-limiting aspect shown, a plurality of guide bosses 1123 may be formed on the first inner frame section 1120a. Such guide bosses 1123 may number two as depicted in the figure. However, the number of the guide bosses 1123 is not limited thereto. The guide bosses 1123 are formed on the top of the first inner frame section 1120a and may be established (or formed) on one side of the through-hole 1122. In various aspects, the guide boss 1123 may be formed in a cylindrical shape. However, the shape of the guide boss is not limited thereto. As described above, the cutout portion 1281 on the flexible circuit board 1200 is connected to the guide boss 1123. Accordingly, in aspects of the present invention, the flexible circuit board 1200 is accurately connected (or fitted) to the mold frame 1100.

In the non-limiting aspect shown, a plurality of protrusions 1124 may be formed on the first inner frame section 1120a. The protrusions 1124 are established (or formed) on the outer circumference of the through-holes 1122 and each one of the protrusions 1124 may be arranged on the left and right of the first inner frame section 1120a. However, the number of the protrusions 1124 is not limited thereto. The fixing holes 1299a, 1299b on the flexible circuit board 1200 may be connected to the protrusions 1124. That is, the flexible circuit board 1200 can be firmly fixed to the mold frame 1100 as the fixing holes 1299a, 1299b formed on the flexible circuit board 1200 and the protrusions 1124 established (or formed) on the first inner frame section 1120a are connected to each other.

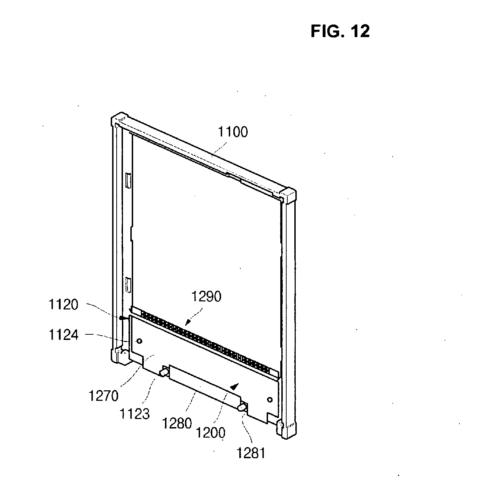

Referring to FIG. 12, a perspective view, in which the flexible circuit board in accordance with an aspect of the present invention is connected to the mold frame, is depicted. As depicted in the figure, the flexible circuit board 1200 may be bent (or folded) to be connected to the mold frame 1100. In the aspect shown, the cutout portion 1281 formed on the flexible circuit board 1200 may be connected to the guide bosses 1123 established (or formed) on the mold frame 1100. In various aspects, the fixing holes 1299a, 1299b formed on the flexible circuit board 1200 may be connected to the protrusions 1124 established on the mold frame 1100. Accordingly, in aspects of the present invention, the flexible circuit board 1200 is placed and accurately fixed (or fitted) on the mold frame 1100 and the position of the flexible circuit board 1200 is not varied in the subsequent manufacturing process.

Accordingly, the assembling process of the light guide plate 1300 and the liquid crystal display panel 1400 that is performed after connecting the flexible circuit board 1200 and the mold frame 1100 to each other would be more precise. That is, the light guide plate 1300 can be optically coupled to the flexible circuit board 1200 and the liquid crystal display panel 1400 can be coupled to the flexible circuit board 1200 more accurately.

In various aspects, although discussed in terms of a particular orientation such as upper and lower for ease of description, various elements need not be so oriented. In various aspects, the elements are independent of the specific orientation, and should be viewed in their relative locations compared to other elements.

Although discussed in terms of a liquid crystal display device, other types of display devices are within the scope of the invention in other aspects.

In various aspects, the flexible circuit board is applicable to cellular phones, portable multimedia players, digital cameras, and/or similar devices.

As described above, the flexible circuit board in accordance with aspects of the present invention minimizes the introduction of light from the light source to the passive elements, conductive patterns, and others by further establishing (or forming) the first light absorbing layer and the second light absorbing layer on the outer circumference of the light sources. Accordingly, aspects of the present invention prevent or reduce the malfunctions of the passive elements and the like, and further improve the image quality of the liquid crystal display panel.

In various aspects, the flexible circuit board in accordance with aspects of the present invention improve the image quality of the liquid crystal display panel by preventing or reducing the emission of light from the light source to undesired areas where the driving module to drive the liquid crystal display panel and the like are positioned.

Furthermore, the flexible circuit board in accordance with aspects of the present invention forms the light sources and the passive elements in the first region thereof, establishes (or forms) the panel connector, to which the liquid crystal display panel is coupled, in the second region thereof, and arranges the controller connector, coupled to the external controller, in the third region thereof. Accordingly, it is possible to electrically connect a large number of parts to each other in a minimum of an area efficiently to thereby easily apply the flexible circuit board to slim and lightweight portable displays.

In addition, the first region, the second region, and the third region of the flexible circuit board in accordance with aspects the present invention include the flexible first and second insulating films. Accordingly, desired areas thereof can be readily bent (or folded) to thereby easily apply the flexible circuit board to various kinds of portable displays having a lot of bending (or folding) portions.

In the liquid crystal display in accordance with aspects of the present invention, the flexible circuit board can be accurately connected to the mold frame by the guide bosses formed on the mold frame. Accordingly, the flexible circuit board and the light guide plate are also optically coupled to each other accurately, and the flexible circuit board and the liquid crystal display panel are also coupled to each other accurately. As a result, the liquid crystal display in accordance with aspects of the present invention improves the image quality remarkably as the defect occurrence rate in the manufacturing process thereof is considerably reduced.

Although a few aspects of the present invention have been shown and described, it would be appreciated by those skilled in the art that changes may be made in the aspects without departing from the principles of the invention, the scope of which is defined in the claims and their equivalents.

## Claims

1. A flexible circuit board (100) for a liquid crystal display comprising:
a first insulating film (110);
a plurality of conductive patterns (120) formed on the first insulating film (110);
a second insulating film (130) formed on the first insulating film (110) to cover the plurality of conductive patterns (120);
at least one light source (140) coupled to the conductive patterns (120);
at least one passive element (150) coupled to the plurality of the conductive patterns (120);
at least one light absorbing layer (160) formed in a peripheral portion of the at least one light source (140) adapted to prevent light from the at least one light source (140) from being emitted to the at least one passive element (150),
a first region (170) in which the at least one light source (140) and the at least one light absorbing layer (160) are formed,
a second region (180) established on one side of the first region (170) adapted to be coupled with a liquid crystal display panel, and
a third region (190) arranged on one side of the second region (180) adapted to be coupled with an external controller (191).

2. The flexible circuit board as claimed in claim 1,
wherein the conductive patterns (120) is a conductive pad (120a).

3. The flexible circuit board according to one of the preceding claims,
wherein the at least one light absorbing layer (160) comprises a first light absorbing layer (161) formed on the first insulating film (110) and at least one second light absorbing layer (162) established on the second insulating film (130) so as to be arranged in an area of the outer circumference of the at least one light source (140).

4. The flexible circuit board as claimed in claim 3, further comprising a window (163) formed on the at least one second light absorbing layer (162) so that the plurality of the conductive pads (120a) to which the at least one light source (140) is coupled are exposed to the outside.

5. The flexible circuit board as claimed in claim 4, wherein the dimensions of the window (163) are greater than those of the plurality of the conductive pads (120a).

6. The flexible circuit board as claimed in one of claims 4 and 5, wherein the circumference of the window (163) is spaced apart from that of the plurality of the conductive patterns by 0.1 mm to 0.4 mm.

7. The flexible circuit board according to one of the preceding claims, wherein the dimensions of the first light absorbing layer (161) are greater than those of the at least one second light absorbing layer (162).

8. The flexible circuit board according to one of the preceding claims, wherein the at least one passive element (150) which is coupled to the plurality of the conductive patterns (120, 120a) is formed in an outer area of the circumference of the at least one second light absorbing layer (162).

9. The flexible circuit board as claimed in claim 8, wherein the first light absorbing layer (161) is formed on a surface of the first insulating film (110) corresponding to the at least one passive element (150).

10. The flexible circuit board according to one of the preceding claims, wherein the at least one second light absorbing layer (162) comprises a front second light absorbing layer (162a) formed toward the front of the light outcoupling facet of the at least one light source and a rear second light absorbing layer (162b) formed toward the rear of the light outcoupling facet of the at least one light source.

11. The flexible circuit board as claimed in claim 10, wherein the dimensions of the front second light absorbing layer (162a) are greater than those of the rear second light absorbing layer (162b) and/or wherein the front second light absorbing layer (162a) and the rear second light absorbing layer (162b) are formed in a shape of a triangle, a. rectangle, and/or a trapezoid, respectively.

12. The flexible circuit board according to one of the claims 10 and 11, wherein the front second light absorbing layer (162a) and the rear second light absorbing layer (162b) are formed in a body of the at least one light source (140) at the outer circumference thereof or wherein the front second light absorbing layer (162a) and the rear second light absorbing layer (162b) are formed spaced apart from each other centered around the at least one light source (140).

13. The flexible circuit board according to one of the preceding claims, wherein the at least one light absorbing layer (160) includes diethylene glycol monoethyl ether acetate, titanium dioxide, and/or epoxy resin and/or wherein the at least one light source (140) is a light emitting diode.

14. The flexible circuit board according to one of the preceding claims, wherein the first insulating film (110) comprises the first region (170) the second region (180) and the third region (190).

15. The flexible circuit board as claimed in claim 14, further comprising:
a cutout region that includes first cutout portions (181) and a second cutout portion (182); and
a panel connector (183) to be coupled to a liquid crystal display further established in the cutout region, wherein the first cutout portions (181) are spaced apart from one another and bisymmetrically formed in the second region (180), and the second cutout portion (182) is formed between the first cutout portions (181).

16. The flexible circuit board as claimed in claim 15, wherein the panel connector (183) includes a conductive pattern that is exposed through the first insulating film (110).

17. The flexible circuit board according to one of the claims 14 - 16, further comprising a controller connector (191) to be coupled to an external controller, and formed in the third region (190).

18. The flexible circuit board as claimed in claim 17, wherein the controller connector (191) comprises a conductive pattern exposed through the first insulating film (110).

19. The flexible circuit board according to one of the preceding claims, further comprising fixing holes provided at opposite positions to each other in the first region and the third region.

20. A liquid crystal display, comprising:
a mold frame (1100), of which the middle is opened;
a flexible circuit board (1200) connected to the mold frame (1100) and including a light source (1240) and a passive element (1250) to provide light to the middle of the mold frame (1100) and fitted to the mold frame (1100) by a first cutout portion (1281) formed thereon
a light guide plate (1300) mounted on the mold frame (1100) and optically coupled to the light source (1240) on the flexible circuit board (1200) to emit light; and
a liquid crystal display panel (1400) to display an image mounted on the light guide plate (1100) corresponding to the inside of the mold frame (1100) and coupled to the flexible circuit board (1200) to display an image, wherein the mold frame (1100) includes a guide boss (1123) to which the first cutout portion (1281) of the flexible circuit board (1200) is connected and fixed,
**characterized in that**
the flexible circuit board (1200) comprises a passive element (1250) and at least one light absorbing layer (160) formed in a peripheral portion of the at least one light source (140) adapted to prevent light from the at least one light source (140) from being emitted to the at least one passive element (150).

21. The liquid crystal display as claimed in claim 20, comprising a flexible circuit board (1200) according to one of the claims 1-19.

22. The liquid crystal display according to one of the claims 20 and 21, wherein the mold frame (1100) further comprises an outer frame (1110), and an inner frame (1120) formed inside the outer frame (1110), and the guide boss (1123)is established on the inner frame (1120).

23. The liquid crystal display as claimed in claim 22, wherein the inner frame (1120) further comprises a first inner frame section (1120a), a second inner frame section (1120b), a third inner frame section (1120c), and a fourth inner frame section (1120d), the first inner frame section (1120a) is formed in an area thereof that does not meet the outer frame (1110), while the second inner frame section (1120b), the third inner frame section (1120c), and the fourth inner frame section (1120d) are established in areas that meet the outer frame (1110), and the first inner frame section (1120a), the second inner frame section (1120b), the third inner frame section(1120c), and the fourth inner frame section (1120d) are connected to each other.

24. The liquid crystal display as claimed in claim 23, wherein the guide boss (1123) is formed on the first inner frame section(1120a).

25. The liquid crystal display according to one of the claims 23 - 24, wherein a plurality of second cutout portions (1121) are formed on the first inner frame section (1120a) and the at least one light source of the flexible circuit board is inserted in to the plurality of the second cutout portions (1121).

26. The liquid crystal display according to one of the claims 23 - 24, further comprising a plurality of through-holes (1122) formed on the first inner frame section (1120a), and the passive element of the flexible circuit board is inserted in to the plurality of the through-holes (1122).

27. The liquid crystal display according to one of the claims 23 - 26, wherein a plurality of fixing holes (1299a, 1299b) is formed on the flexible circuit board.

28. The liquid crystal display according to one of the claims 23 - 27, further comprising a plurality of protrusions (1124) formed on the first inner frame section (1120a), wherein the plurality of the fixing holes (1299a, 1299b) are inserted into the protrusions (1124).

29. The liquid crystal display according to one of the claims 20 - 28, wherein the guide boss (1123) is cylindrical in shape.

30. The liquid crystal display according to one of the claims 22 - 29, wherein the outer frame is ⊏ in shape.

31. The liquid crystal display as claimed in claim 30, wherein the thickness of the outer frame (1110) is greater than that of the inner frame (1120).

32. The liquid crystal display according to one of the claims 22 - 31, wherein the light source is connected to the conductive patterns in a first section (170); a panel connector (183) of the conductive patterns and an ink layer (185) is formed in a second section (180); and a controller connector (191) of the conductive patterns is formed in a third section (190); and
wherein the light absorbing layer (160) is formed over portions of the light source (140) and the first section (170), and the second section (180) is folded over one side of the first section (170) and the third section (190) is folded over another side of the first section (170).

## Patentansprüche

1. Flexible Leiterplatte (100) für eine Flüssigkristallanzeige mit :
einem ersten Isolierfilm (110) ;
einer Vielzahl von Leiterbildern (120), die auf dem ersten Isolierfilm (110) gebildet sind ;
einem zweiten Isolierfilm (130), der auf dem ersten Isolierfilm (110) gebildet ist, um die Vielzahl von Leiterbildern (120) abzudecken ;
mindestens einer Lichtquelle (140), die mit den Leiterbildern (120) verbunden ist ;
mindestens einem passiven Element (150), das mit der Vielzahl von Leiterbildern (120) verbunden ist ;
mindestens einer lichtabsorbierenden Schicht (160), die in einem Umfangsabschnitt der mindestens einen Lichtquelle (140) gebildet ist, und dazu dient, Licht aus der mindestens einen Lichtquelle (140) daran zu hindern, dass es auf das mindestens eine passive Element (150) ausgestrahlt wird,
einem ersten Bereich (170), in dem die mindestens eine Lichtquelle (140) und die mindestens eine lichtabsorbierende Schicht (160) gebildet sind,
einem zweiten Bereich (180), der auf einer Seite des ersten Bereichs (170) gebildet ist, und mit einer Flüssigkristallanzeige-Tafel (LCD-Tafel) verbunden wird, und
einem dritten Bereich (190), der auf einer Seite des zweiten Bereichs (180) angeordnet ist, und mit einem externen Controller (191) verbunden wird.

2. Flexible Leiterplatte nach Anspruch 1,
wobei es sich bei den Leiterbildern (120) um eine leitende Kontaktfläche (120a) handelt.

3. Flexible Leiterplatte nach einem der vorhergehenden Ansprüche, wobei die
mindestens eine lichtabsorbierende Schicht (160) eine erste lichtabsorbierende Schicht (161) umfasst, die auf dem ersten Isolierfilm (110) gebildet ist, und mindestens eine zweite lichtabsorbierende Schicht (162), die auf dem zweiten Isolierfilm (130) gebildet ist, so dass sie in einem Bereich des äußeren Umfangs der mindestens einen Lichtquelle (140) angeordnet ist.

4. Flexible Leiterplatte nach Anspruch 3, die weiterhin ein Fenster (163) umfasst, das an der mindestens einen zweiten lichtabsorbierenden Schicht (162) gebildet ist, so dass die Vielzahl der leitenden Kontaktflächen (120a), mit denen die mindestens eine Lichtquelle (140) verbunden ist, nach außen belichtet wird.

5. Flexible Leiterplatte nach Anspruch 4, wobei die Abmessungen des Fensters (163) größer sind als die der Vielzahl der leitenden Kontaktflächen (120a).

6. Flexible Leiterplatte nach einem der Ansprüche 4 und 5, wobei der Umfang des Fensters (163) um 0,1 mm bis 0,4 mm zu dem der Vielzahl der Leiterbilder beabstandet ist.

7. Flexible Leiterplatte nach einem der vorhergehenden Ansprüche, wobei die Abmessungen der ersten lichtabsorbierenden Schicht (161) größer sind als die der mindestens einen zweiten lichtabsorbierenden Schicht (162).

8. Flexible Leiterplatte nach einem der vorhergehenden Ansprüche, wobei das mindestens eine passive Element (150), das mit der Vielzahl der Leiterbilder (120, 120a) verbunden ist, in einem Außenbereich des Umfangs der mindestens einen zweiten lichtabsorbierenden Schicht (162) gebildet ist.

9. Flexible Leiterplatte nach Anspruch 8, wobei die erste lichtabsorbierende Schicht (161) auf einer Oberfläche des ersten Isolierfilms (110), der dem mindestens einen passiven Element (150) entspricht, gebildet ist.

10. Flexible Leiterplatte nach einem der vorhergehenden Ansprüche, wobei die mindestens eine zweite lichtabsorbierende Schicht (162) eine vordere zweite lichtabsorbierende Schicht (162a) umfasst, die in Richtung der Vorderseite der lichtauskoppelnden Facette der mindestens einen Lichtquelle gebildet ist, und eine hintere zweite lichtabsorbierende Schicht (162b) umfasst, die in Richtung der Rückseite der lichtauskoppelnden Facette der mindestens einen Lichtquelle gebildet ist.

11. Flexible Leiterplatte nach Anspruch 10, wobei die Abmessungen der vorderen zweiten lichtabsorbierenden Schicht (162a) größer sind als die der hinteren zweiten lichtabsorbierenden Schicht (162b), und / oder wobei die vordere zweite lichtabsorbierende Schicht (162a) und die hintere zweite lichtabsorbierende Schicht (162b) in der Form eines Dreiecks, eines Rechtecks bzw. eines Trapezes gebildet sind.

12. Flexible Leiterplatte nach einem der Ansprüche 10 und 11, wobei die vordere zweite lichtabsorbierende Schicht (162a) und die hintere zweite lichtabsorbierende Schicht (162b) an dem äußeren Umfang eines Hauptteils der mindestens einen Lichtquelle (140) gebildet sind, oder wobei die vordere zweite lichtabsorbierende Schicht (162a) und die hintere zweite lichtabsorbierende Schicht (162b) in einem Abstand zueinander zentriert um die mindestens eine Lichtquelle (140) herum gebildet sind.

13. Flexible Leiterplatte nach einem der vorhergehenden Ansprüche, wobei die mindestens eine lichtabsorbierende Schicht (160) Diethylen-Glycol-Monoethyl-Ether-Acetat, Titandioxid und / oder Epoxidharz enthält und / oder wobei die mindestens eine Lichtquelle (140) eine lichtemittierende Diode (Leuchtdiode - LED) ist.

14. Flexible Leiterplatte nach einem der vorhergehenden Ansprüche, wobei der erste Isolierfilm (110) den ersten Bereich (170), den zweiten Bereich (180) und den dritten Bereich (190) umfasst.

15. Flexible Leiterplatte nach Anspruch 14, die weiterhin folgendes besitzt :
einen Ausschnittbereich, der erste Ausschnitte (181) und einen zweiten Ausschnitt (182) umfasst ; und
einen Flachsteckverbinder (183), der mit einer Flüssigkristallanzeige verbunden wird, die sich weiterhin in dem Ausschnitt befindet, wobei die ersten Ausschnitte (181) zueinander beabstandet und bisymmetrisch in dem zweiten Bereich (180) gebildet sind, und der zweite Ausschnitt (182) zwischen den ersten Ausschnitten (181) gebildet ist.

16. Flexible Leiterplatte nach Anspruch 15, wobei der Flachsteckverbinder (183) ein Leiterbild (120) umfasst, das durch den ersten Isolierfilm (110) belichtet wird.

17. Flexible Leiterplatte nach einem der Ansprüche 14 - 16, die weiterhin einen Controller-Stecker (191) besitzt, der mit einem externen Controller verbunden und in dem dritten Bereich (190) gebildet wird.

18. Flexible Leiterplatte nach Anspruch 17, wobei der Controller-Stecker (191) ein Leiterbild besitzt, das durch den ersten Isolierfilm (110) belichtet wird.

19. Flexible Leiterplatte nach einem der vorhergehenden Ansprüche, die weiterhin Befestigungsbohrungen an zueinander gegenüberliegenden Positionen in dem ersten Bereich und in dem dritten Bereich besitzt.

20. Flüssigkristallanzeige mit :
einem Formrahmen (1100), dessen Mittelteil geöffnet ist;
einer flexiblen Leiterplatte (1200), die mit dem Formrahmen (1100) verbunden ist, und eine Lichtquelle (1240) und ein passives Element (1250) umfasst, um der Mitte des Formrahmens (1100) Licht zuzuführen, und die durch einen ersten Ausschnitt (1281), der darauf gebildet ist, an dem Formrahmen (1100) befestigt ist ;
einer Lichtleitplatte (1300), die an dem Formrahmen (1100) befestigt ist und optisch mit der Lichtquelle (1240) an der flexiblen Leiterplatte (1200) verbunden ist, um Licht abzugeben ; und
einer Flüssigkristallanzeige-Tafel (LCD-Tafel) (1400) zur Anzeige eines Bildes, das an der Lichtleitplatte (1100) angebracht ist und dem Inneren des Formrahmens (1100) entspricht, und mit der flexiblen Leiterplatte (1200) verbunden ist, um ein Bild zu zeigen, wobei der Rahmen (1100) einen runden Führungsvorsprung (1123) besitzt, mit dem der erste Ausschnitt (1281) verbunden ist und an dem er befestigt ist,
**dadurch gekennzeichnet, dass**
die flexible Leiterplatte (1200) ein passives Element (1250) und mindestens eine lichtabsorbierende Schicht (160) besitzt, die in einem Umfangsabschnitt der mindestens einen Lichtquelle (140) gebildet ist, und verhindern soll, dass Licht aus der mindestens einen Lichtquelle (140) zu dem mindestens einen passiven Element (150) ausgestrahlt wird.

21. Flüssigkristallanzeige nach Anspruch 20 mit einer flexiblen Leiterplatte (1200) nach einem der Ansprüche 1 bis 19.

22. Flüssigkristallanzeige nach einem der Ansprüche 20 und 21, wobei der Formrahmen (1100) weiterhin einen Außenrahmen (1110) und einen Innenrahmen (1120) umfasst, der innerhalb des Außenrahmens (1110) gebildet ist, und der runde Führungsvorsprung (1123) an dem Innenrahmen (1120) gebildet ist.

23. Flüssigkristallanzeige nach Anspruch 22, wobei der Innenrahmen (1120) weiterhin einen ersten Innenrahmenabschnitt (1120a), einen zweiten Innenrahmenabschnitt (1120b), einen dritten Innenrahmenabschnitt (1120c) und einen vierten Innenrahmenabschnitt (1120d) besitzt, wobei der erste Innenrahmenabschnitt (1120a) in einem Bereich davon gebildet ist, der den Außenrahmen (1110) nicht berührt, während der zweite Innenrahmenabschnitt (1120b), der dritte Innenrahmenabschnitt (1120c) und der vierte Innenrahmenabschnitt (1120d) in Bereichen gebildet ist, die den Außenrahmen (1110) berühren, und der erste Innenrahmenabschnitt (1120a), der zweite Innenrahmenabschnitt (1120b), der dritte Innenrahmenabschnitt (1120c) und der vierte Innenrahmenabschnitt (1120d) miteinander verbunden sind.

24. Flüssigkristallanzeige nach Anspruch 23, wobei der runde Führungsvorsprung (1123) an dem ersten Innenrahmenabschnitt (1120a) gebildet ist.

25. Flüssigkristallanzeige nach einem der Ansprüche 23 bis 24, wobei eine Vielzahl zweiter Ausschnitte (1121) an dem ersten Innenrahmenabschnitt (1120a) gebildet ist und die mindestens eine Lichtquelle der flexiblen Leiterplatte in die Vielzahl der zweiten Ausschnitte (1121) eingeschoben ist.

26. Flüssigkristallanzeige nach einem der Ansprüche 23 bis 24, die weiterhin eine Vielzahl von Durchgangsbohrungen (1122) besitzt, die an dem ersten Innenrahmenabschnitt (1120a) gebildet sind, und das passive Element der flexiblen Leiterplatte ist in die Vielzahl der Durchgangsbohrungen (1122) eingeschoben.

27. Flüssigkristallanzeige nach einem der Ansprüche 23 bis 26, wobei eine Vielzahl von Befestigungsbohrungen (1299a, 1299b) an der flexiblen Leiterplatte gebildet ist.

28. Flüssigkristallanzeige nach einem der Ansprüche 23 bis 27, die weiterhin eine Vielzahl von Vorsprüngen (1124) besitzt, die an dem ersten Innenrahmenabschnitt (1120a) gebildet sind, wobei die Vielzahl von Befestigungsbohrungen (1299a, 1299b) in die Vorsprünge (1124) eingeschoben ist.

29. Flüssigkristallanzeige nach einem der Ansprüche 20 bis 28, wobei der runde Führungsvorsprung (1123) zylinderförmig ist.

30. Flüssigkristallanzeige nach einem der Ansprüche 22 bis 29, wobei der Außenrahmen C-förmig ist.

31. Flüssigkristallanzeige nach Anspruch 30, wobei die Stärke des Außenrahmens (1110) größer ist als die des Innenrahmens (1120).

32. Flüssigkristallanzeige nach einem der Ansprüche 22 bis 31, wobei die Lichtquelle mit den Leiterbildern in einem ersten Abschnitt (170) verbunden ist ; ein Flachsteckverbinder (183) der Leiterbilder und eine Tintenschicht (185) in einem zweiten Abschnitt (180) gebildet ist ; und ein Controller-Stecker (191) der Leiterbilder in einem dritten Abschnitt (190) gebildet ist ; und
wobei die lichtabsorbierende Schicht (160) über Bereichen der Lichtquelle (140) und des ersten Abschnittes (170) gebildet ist, und der zweite Abschnitt (180) über eine Seite des ersten Abschnittes (170) geklappt ist, und der dritte Abschnitt (190) über eine andere Seite des ersten Abschnittes (170) geklappt ist.

## Revendications

1. Carte de circuit flexible (100) pour un affichage à cristaux liquides comportant :
un premier film isolant (110) ;
une pluralité des placages métalliques sélectifs (120) formée sur le premier film isolant (110) ;
un deuxième film isolant (110) formé sur le premier film isolant (110) pour couvrir la pluralité des placages métalliques sélectifs (120) ;
au moins une source lumineuse (140) couplée aux placages métalliques sélectifs (120) ;
au moins un élément passif (150) couplé à la pluralité des placages métalliques sélectifs (120) ;
au moins une couche absorbant la lumière (160) formée dans une portion périphérique d'au moins une source lumineuse (140) adaptée pour empêcher que de la lumière d'au moins une source lumineuse (140) soit émise à l'au moins un élément passif (150) ;
une première région (170) dans laquelle l'au moins une source lumineuse (140) et l'au moins une couche absorbant la lumière (160) sont formées ;
une deuxième région (180) établie sur un côté de la première région (170) adaptée pour être couplée à un écran d'affichage à cristaux liquides, et
une troisième région (190) agencée sur un côté de la deuxième région (180) adaptée pour être couplée à un contrôleur extérieur (191).

2. Carte de circuit flexible selon la revendication 1,
les placages métalliques sélectifs (120) étant une surface de contact conductrice (120a).

3. Carte de circuit flexible selon l'une quelconque des revendications précédentes,
l'au moins une couche absorbant la lumière (160) comportant une première couche absorbant la lumière (161) formée sur le premier film isolant (110) et au moins une deuxième couche absorbant la lumière (162) étant établie sur le deuxième film isolant (130) de manière qu'elle est agencée dans une zone de la circonférence extérieure d'au moins une source lumineuse (140).

4. Carte de circuit flexible (100) selon la revendication 3, comportant en outre une fenêtre (163) formée sur l'au moins une deuxième
couche absorbant la lumière (162) de manière que la pluralité des surfaces de contact conductrices (120a) auxquelles l'au moins une source lumineuse (140) est couplé est exposée vers l'extérieur.

5. Carte de circuit flexible (100) selon la revendication 4, les dimensions de la fenêtre (163) étant supérieures aux dimensions de la pluralité des surfaces de contact conductrices (120a).

6. Carte de circuit flexible (100) selon l'une quelconque des revendications 4 et 5, la circonférence de la fenêtre (163) étant espacée de celle de la pluralité des placages métalliques sélectifs (120) par 0,1 mm à 0,4 mm.

7. Carte de circuit flexible (100) selon l'une quelconque des revendications précédentes, les dimensions de la première couche absorbant la lumière (161) étant supérieures aux dimensions de l'au moins une deuxième couche absorbant la lumière (162).

8. Carte de circuit flexible selon l'une quelconque des revendications précédentes, l'au moins un élément passif (150) couplé au pluralité des placages métalliques sélectifs (120, 120a) étant formé dans une zone extérieure de la circonférence de l'au moins une deuxième couche absorbant la lumière (162).

9. Carte de circuit flexible selon la revendication 8, la première couche absorbant la lumière (161) étant formée sur une surface du premier film isolant (110) correspondant à l'au moins un élément passif (150).

10. Carte de circuit flexible selon l'une quelconque des revendications précédentes, l'au moins une deuxième couche absorbant la lumière (162) comportant une deuxième couche avant absorbant la lumière (162a) formée vers le front de la facette déclenchante de la lumière de l'au moins une source lumineuse, et une deuxième couche arrière absorbant la lumière (162b) formée vers l'arrière de la facette déclenchante de la lumière de l'au moins une source lumineuse.

11. Carte de circuit flexible (100) selon la revendication 10, les dimensions de la deuxième couche avant absorbant la lumière (162a) étant supérieures aux dimensions de la deuxième couche arrière absorbant la lumière (162b) et / ou la deuxième couche avant absorbant la lumière (162a) et la deuxième couche arrière absorbant la lumière (162b) étant formée en forme de triangle, de rectangle et / ou de trapèze.

12. Carte de circuit flexible selon l'une quelconque des revendications 10 et 11, la deuxième couche avant absorbant la lumière (162a) et la deuxième couche arrière absorbant la lumière (162b) étant formée dans un corps de l'au moins une source lumineuse (140) à son circonférence extérieure ou la deuxième couche avant absorbant la lumière (162a) et la deuxième couche arrière absorbant la lumière (162b) étant formée espacée l'une de l'autre centrée autours l'au moins une source lumineuse (140).

13. Carte de circuit flexible selon l'une quelconque des revendications précédentes, l'au moins une couche absorbant la lumière (160) comportant de l'acétate de diéthylène-glycol mono éthyle éther, du dioxyde de titane et / ou de la résine d'époxyde et / ou l'au moins une source lumineuse (140) étant une diode électroluminescente.

14. Carte de circuit flexible (100) selon l'une quelconque des revendications précédentes, le premier film isolant (110) comportant la première région (170), la deuxième région (180) et la troisième région (190).

15. Carte de circuit flexible (100) selon la revendication 14, comportant en outre :
une région de découpe présentant des premières portions de découpe (181) et une deuxième portion de découpe (182) ; et
un connecteur de panneau (183) à être couplé à un affichage à cristaux liquides établi en outre dans la région de découpe, les premières portions de découpe (181) étant espacées l'une de l'autre et formées bi-symétriquement dans la deuxième région (180), et la deuxième portion de découpe (182) étant formée entre les premières portions de découpe (181).

16. Carte de circuit flexible selon la revendication 15, le connecteur de panneau (183) comportant un placage métallique sélectif qui est exposé par le premier film isolant (110).

17. Carte de circuit flexible selon l'une quelconque des revendications 14 à 16, comportant en outre un contrôleur-connecteur (191) à être couplé à un contrôleur extérieur, et formé dans la troisième région (190).

18. Carte de circuit flexible selon la revendication 17, le contrôleur-connecteur (191) comportant un placage métallique sélectif exposé par le premier film isolant (110).

19. Carte de circuit flexible selon l'une quelconque des revendications précédentes comportant en outre des trous de fixation prévus à des positions opposées les uns par rapport aux autres dans la première région et la troisième région.

20. Affichage à cristaux liquides comportant :
un cadre moulé (1100) dont le centre est ouvert ;
une carte de circuit flexible (1200) relié au cadre moulé (1100) et comprenant une source lumineuse (1240) et un élément passif (1250) pour fournir de la lumière au centre du cadre moulé (1100) et fixée au cadre moulé (1100) par une première portion de découpe (1281) y formée ;
une plaque de guidage de lumière (1300) montée sur le cadre moulé (1100) et couplée optiquement à la source lumineuse (1240) sur la carte de circuit flexible (1200) pour émettre de la lumière ; et
un écran d'affichage à cristaux liquides (1400) pour afficher une image montée sur la plaque de guidage de lumière (1100) correspondant à l'intérieur du cadre moulé (1100) et couplé à la carte de circuit flexible (1200) pour afficher une image, le cadre moulé (1100) comportant une bosse de guidage (1123) auquel la première portion de découpe (1281) de la carte de circuit flexible (1200) est lié et fixé,
**caractérisé en ce que**
la carte de circuit flexible (1200) comporte un élément passif (1250) et au moins une couche absorbant la lumière (160) formée dans une portion périphérique de l'au moins une source lumineuse (140) adaptée pour empêcher que de la lumière d'au moins une source lumineuse (140) soit émise à l'au moins un élément passif (150).

21. Affichage à cristaux liquides selon la revendication 20, comportant une carte de circuit flexible (1200) selon l'une quelconque des revendications 1 à 19.

22. Affichage à cristaux liquides selon l'une quelconque des revendications 20 et 21, le cadre moulé (1100) comportant en outre un cadre extérieur (1110) et un cadre intérieur (1120) formé à l'intérieur du cadre extérieur (1110) et la bosse de guidage (1123) étant formé au cadre intérieur (1120).

23. Affichage à cristaux liquides selon la revendication 22, le cadre intérieur (1120) comportant en outre une première section de cadre intérieur (1120a), une deuxième section de cadre intérieur (1120b), une troisième section de cadre intérieur (1120c) et une quatrième section de cadre intérieur (1120d), la première section de cadre intérieur (1120a) étant formée dans une zone de celle-ci qui ne touche pas le cadre extérieur (1110), tandis que la deuxième section de cadre intérieur (1120b), la troisième section de cadre intérieur (1120c) et la quatrième section de cadre intérieur (1120d) sont établies dans des zones qui touchent le cadre extérieur (1110), et la première section de cadre intérieur (1120a), la deuxième section de cadre intérieur (1120b), la troisième section de cadre intérieur (1120c) et la quatrième section de cadre intérieur (1120d) étant liées les unes aux autres.

24. Affichage à cristaux liquides selon la revendication 23, la bosse de guidage (1123) étant formé à la première section de cadre intérieur (1120a).

25. Affichage à cristaux liquides selon l'une quelconque des revendications 23 à 24, une pluralité des deuxièmes portions de découpe (1121) étant formée à la première section de cadre intérieur (1120a) et l'au moins une source lumineuse (140) de la carte de circuit flexible étant insérée dans la pluralité des deuxièmes portions de découpe (1121).

26. Affichage à cristaux liquides selon l'une quelconque des revendications 23 à 24, comportant en outre une pluralité des trous débouchants (1122) formée à la première section de cadre intérieur (1120a) et l'élément passif de la carte de circuit flexible étant inséré dans la pluralité des trous débouchants (1122).

27. Affichage à cristaux liquides selon l'une quelconque des revendications 23 à 26, une pluralité des trous de fixation (1299a, 1299b) étant formée sur la carte de circuit flexible.

28. Affichage à cristaux liquides selon l'une quelconque des revendications 23 à 27, comportant en outre une pluralité des saillies (1124) formée à la première section de cadre intérieur (1120a), la pluralité des trous de fixation (1299a, 1299b) étant insérée dans les saillies (1124).

29. Affichage à cristaux liquides selon l'une quelconque des revendications 20 à 28, la bosse de guidage (1123) présentant une forme cylindrique.

30. Affichage à cristaux liquides selon l'une quelconque des revendications 22 à 29, le cadre extérieur présentant une forme en C.

31. Affichage à cristaux liquides selon la revendication 30, l'épaisseur du cadre extérieur (1110) étant supérieure à l'épaisseur du cadre intérieur (1120).

32. Affichage à cristaux liquides selon l'une quelconque des revendications 22 à 31, la source lumineuse étant liée aux placages métalliques sélectifs dans une première section (170) ; un connecteur de panneau (183) des placages métalliques sélectifs et une couche d'encre (185) étant formé dans une deuxième section (180) ; et un contrôleur-connecteur (191) des placages métalliques sélectifs étant formé dans une troisième section (190) ; et
la couche absorbant la lumière (160) étant formée au-dessus des portions de la source lumineuse (140) et la première section (170), et la deuxième section (180) étant pliée sur un côté de la première section (170), et la troisième section (190) étant pliée sur un autre côté de la première section (170).
